# EUROPEAN PATENT SPECIFICATION

(11) **EP 4 549 965 B1**
(45) Date of publication and mention of the grant of the patent: **12.08.2026**
(21) Application number: 24205283.5
(22) Date of filing: 08.10.2024
(51) Int. Cl.: G01R 31/327

(54) **METHOD AND SYSTEM FOR DIAGNOSING RETENTION CIRCUIT**
VERFAHREN UND SYSTEM ZUR DIAGNOSE EINER RETENTIONSSCHALTUNG
PROCÉDÉ ET SYSTÈME DE DIAGNOSTIC DE CIRCUIT DE RÉTENTION

(30) Priority: 02.11.2023 KR 20230150358
(43) Date of publication of application: 07.05.2025
(73) Proprietor: SAMSUNG SDI CO., LTD., Yongin-si, Gyeonggi-do 17084 (KR)
(72) Inventor: KIM, Hyunjun, Yongin-Si 17084 (KR)
(74) Representative: Marks & Clerk LLP

(56) References cited:
- EP-B1- 3 823 001
- CN-A- 114 184 953
- US-A1- 2020 124 672

## Description

### BACKGROUND

### 1. Field

Aspects of embodiments of the present disclosure relate to method and system for diagnosing retention circuit.

### 2. Description of the Related Art

Unlike primary batteries that are not designed to be recharged, secondary (or rechargeable) batteries are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage).

The secondary batteries are connected to electronic devices through contactors, and if the electronic devices perform abnormal operations, control signals for controlling the contactors are unable to be maintained, which may result in a serious accident. For example, if controllers for controlling the contactors are reset due to an error(s) of the controllers in electric vehicles driven by secondary batteries, electrical connections between the secondary batteries and the vehicle bodies may be unintentionally cut. If vehicles are traveling at a high speed, cutting of the electrical connection may lead to a fatal accident.

The above information disclosed in this Background section is for enhancement of understanding of the background of the present disclosure, and therefore, it may contain information that does not constitute related (or prior) art.

### SUMMARY

Embodiments of the present disclosure provide method and system for diagnosing a retention circuit used to maintain an operation state of a contactor.

These and other aspects of the present disclosure will be described in or will be apparent from the following description of embodiments of the present disclosure.

To solve the above, a retention circuit diagnostic system includes a first retention circuit configured to output a retention signal for controlling a contactor, and a controller configured to transmit a first signal related to a state control of the contactor, and to transmit a second signal for activating the first retention circuit, and configured to diagnose the first retention circuit based on the retention signal.

The controller may be configured to determine that the first retention circuit operates normally based on the retention signal being within a predetermined or high level range.

The controller may be configured to determine whether the contactor is in an open state or in a closed state, and is configured to transmit the second signal to the first retention circuit based on the contactor being in the open state.

The controller may be configured to initialize the first retention circuit based on completion of a diagnosis of the first retention circuit.

The controller may be configured to output fault information based on the first retention circuit performing an abnormal operation.

The retention circuit diagnostic system may further include a second retention circuit, wherein the controller is configured to transmit the first signal and the second signal to the second retention circuit, and to diagnose the second retention circuit based on a retention signal output from the second retention circuit.

The retention circuit diagnostic system may further include a contactor drive circuit configured to drive the contactor, wherein the retention signal output from the first retention circuit and the retention signal output from the second retention circuit are logically added together to generate an ORed signal to be input to the contactor drive circuit.

The first retention circuit may be configured to receive at least one of the first signal or the second signal, wherein the second retention circuit is configured to receive at least one of the first signal or the second signal. For example, at least one of the first signal and the second signal may be input to the first retention circuit, and at least one of the first signal and the second signal may be input to the second retention circuit.

To solve the above, a retention circuit diagnostic system includes a first retention circuit configured to output a first retention signal for controlling a first contactor, a second retention circuit configured to output a second retention signal for controlling a second contactor, and a controller configured to generate a test signal for testing each of the first retention circuit and the second retention circuit, and configured to diagnose at least one of the first retention circuit or the second retention circuit based on at least one of the first retention signal or the second retention signal.

The controller may be configured to determine that the first retention circuit performs an abnormal operation based on the first retention signal being out of a level range.

The controller may be configured to output fault information based on one of the first retention circuit or the second retention circuit performing an abnormal operation.

The retention circuit diagnostic system may further include a third retention circuit, wherein the controller is configured to diagnose the third retention circuit based on a third retention signal output from the third retention circuit based on the test signal.

The retention circuit diagnostic system may further include a first contactor drive circuit configured to drive the first contactor, and a second contactor drive circuit configured to drive the second contactor, wherein the first retention signal and the third retention signal are logically added together to generate an ORed signal input to the first contactor drive circuit, and wherein the second retention signal and the third retention signal are logically added together to generate another ORed signal input to the second contactor drive circuit.

The test signal may include a first signal related to a state control of the first contactor, a second signal for activating the first retention circuit, the second retention circuit, and the third retention circuit, and a third signal related to a state control of the second contactor, wherein at least one of the first signal or the second signal is input to the first retention circuit, wherein at least one of the second signal or the third signal is input to the second retention circuit, and wherein at least one of the first signal, the second signal, or the third signal is input to the third retention circuit.

The first contactor may be connected to a high potential terminal, and wherein the second contactor is connected to a low potential terminal.

To solve the above, a diagnosis method of a retention circuit, which is performed by at least one processor, includes transmitting a first signal related to a state control of a contactor, and a second signal for activating the retention circuit, to the retention circuit, obtaining a retention signal output from the retention circuit, and diagnosing whether the retention circuit performs a normal operation based on the retention signal.

The first signal may be of a high level, wherein the method further includes determining that the retention circuit performs a normal operation based on the retention signal being within a high level range.

The first signal may be of a low level, wherein the method further includes determining the retention circuit performs a normal operation based on the obtained retention signal being within a low level range.

According to one of more embodiments, in the transmitting of the first signal and the second signal to the retention circuit, the first signal of a high level may be transmitted to the retention circuit, and in the diagnosing whether the retention circuit performs the normal operation, in a case where the obtained retention signal is within a high level range, the retention circuit may be determined to perform a normal operation.

According to one of more embodiments, in the transmitting of the first signal and the second signal to the retention circuit, the first signal of a low level may be transmitted to the retention circuit, and in the diagnosing whether the retention circuit performs a normal operation, in a case where the obtained retention signal is within a low level range, the retention circuit may be determined to perform a normal operation.

The transmitting of the first signal and the second signal to the retention circuit may include obtaining a state of the contactor, and transmitting the second signal to the retention circuit based on the contactor being in an open state.

The diagnosis method may further include initializing the retention circuit, for example after diagnosing whether the retention circuit performs a normal operation.

According to embodiments of the present disclosure, a state of a retention circuit for reducing the likelihood of or preventing abnormal opening of a contactor connecting a secondary battery to an external electronic device may be diagnosed. It is possible to reduce the likelihood of or prevent the contactor being opened due to an abnormal operation of the retention circuit.

According to embodiments of the present disclosure, a plurality of retention circuits may be provided to reduce the likelihood of or prevent abnormal opening of a contactor, and even if a corresponding or specific retention circuit performs an abnormal operation, another retention circuit provided in reserve may transmit a retention signal to a contactor drive circuit. Even if the retention circuit performs an abnormal operation, the retention signal may be stably supplied to the contactor drive circuit.

According to embodiments of the present disclosure, the likelihood of an opening of a contactor due to an abnormal operation of a retention circuit may be reduced or the contactor may be prevented from being opened due to an abnormal operation of a retention circuit, and the likelihood of an accident due to the opening of the contactor may be reduced or an accident due to the opening of the contactor may be prevented.

At least some of the above and other features of the invention are set out in the claims.

Aspects of the present disclosure are not limited to those described above, and other aspects not mentioned will be clearly understood by a person skilled in the art from the detailed description, described below.

### BRIEF DESCRIPTION OF DRAWINGS

The following drawings attached to this specification illustrate embodiments of the present disclosure, and further describe aspects of the present disclosure together with the detailed description of the present disclosure. Thus, the present disclosure should not be construed as being limited to the drawings:
FIG. 1 illustrates a schematic diagram showing a retention circuit diagnostic system according to one or more embodiments of the present disclosure;
FIG. 2 illustrates a configuration of a retention device of FIG. 1, according to one or more embodiments of the present disclosure;
FIG. 3 illustrates a flowchart showing a diagnosis method of a retention circuit, according to one or more embodiments of the present disclosure;
FIG. 4 illustrates a flowchart showing operation S330 of FIG. 3 in more detail, according to one or more embodiments of the present disclosure;
FIG. 5 illustrates a schematic diagram showing a retention circuit diagnostic system according to one or more other embodiments of the present disclosure;
FIG. 6 illustrates a configuration of a first retention device of FIG. 5, according to one or more other embodiments of the present disclosure;
FIG. 7 illustrates a flowchart showing a diagnosis method of a retention circuit, according to one or more other embodiments of the present disclosure;
FIG. 8 illustrates a schematic diagram showing a retention circuit diagnostic system according to one or more other embodiments of the present disclosure; and
FIG. 9 illustrates a connection structure of a plurality of retention circuits according to one or more other embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the aspects of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of local patent laws.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be located in contact with the upper (or lower) surface of the element, and another element may also be interposed between the element and the arbitrary element located on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Furthermore, the term "module", "unit", or "portion" used in the specification refers to a software or hardware component, and the "module", "unit", or "portion" performs certain functions. However, the "module", "unit", or "portion" is not limited to software or hardware. The "module", "unit", or "portion" may also be configured to be included in an addressable storage medium and may also be configured to operate one or more processors. Accordingly, for example, the "module", "unit", or "portion" may include at least one of components, such as software components, object-oriented software components, class components, or task components, processes, functions, properties, procedures, subroutines, segments of program code, drivers, firmware, microcode, circuits, data, databases, data structures, tables, arrays, and variables. The components and "modules", "units", or "portions" may be combined into smaller numbers of components and "modules", "units", or "portions" or may be further divided into additional components and "modules", "units", or "portions".

Hereinafter, various embodiments of the present disclosure will be described in detail with reference to the attached drawings.

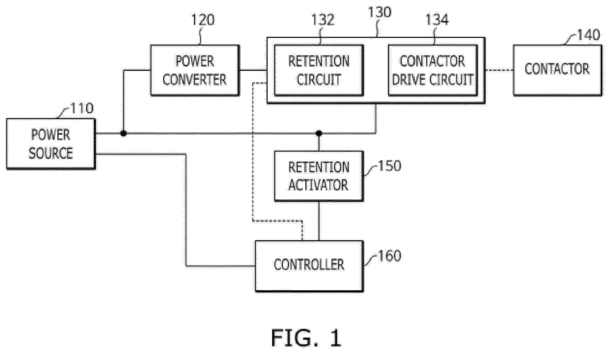

FIG. 1 illustrates a schematic diagram showing a retention circuit diagnostic system according to one or more embodiments of the present disclosure. In FIG. 1, dotted lines may be power lines or control lines.

Referring to FIG. 1, the retention circuit diagnostic system may include a power source 110, a power converter 120, a retention device 130, a contactor 140, a retention activator 150, and a controller 160.

The power source 110 may supply power to respective components. Furthermore, the power source 110 may include a plurality of power sources of different standards. For example, the power source 110 may include a first power source, a second power source, a third power source, and so on, and the power capacity may gradually increase from the first power source to the third power source.

The power converter 120 may receive power from the power source 110, may convert the supplied power into power of a level (e.g., predetermined level), and may supply the converted power to the retention device 130. For example, the power converter 120 may convert the direct current (DC) power supplied from the power source 110 into DC power of a specific or a corresponding level, and may supply the DC power to the retention device 130. According to one or more embodiments, the power converter 120 may convert the DC power into DC power of a plurality of levels, and may supply the converted DC power to the retention device 130.

The contactor 140 may be connected to a high potential terminal (e.g., a positive terminal) or a low potential terminal (e.g., a negative terminal) to form a path for supplying power to a corresponding terminal. In one or more embodiments, the contactor 140 may include various types of switching devices that control an electrical connection between two nodes. For example, the contactor 140 may include a relay, which is a switch that operates at a relatively low speed, and a field effect transistor (FET) or transistor, which is a switch that operates at a relatively high speed. Furthermore, in the present disclosure, the contactor 140 may be in an open state or in a closed state. The open state may mean a state in which two contact points connected to the contactor 140 are electrically disconnected from each other, for example, an OFF state. Furthermore, the closed state may mean that the two contact points connected to the contactor 140 are electrically connected to each other, for example, an ON state (or conducted or short-circuited). The two nodes connected to the contactor 140 may be respectively a power node of an electronic device and a load node of the electronic device. For example, the contactor 140 may be located on a large-current path of an electronic device, and may be used to control a large current.

The retention device 130 may operate by receiving power from the power converter 120. The retention device 130 may include a retention circuit 132 and a contactor drive circuit 134 to stably control the contactor 140.

According to one or more embodiments, if a first signal for controlling the contactor 140 from the controller 160 is not received due to an abnormal operation of the controller 160, etc., the retention circuit 132 may operate for a time (e.g., predetermined time), and may transmit a retention signal to the contactor drive circuit 134. According to one or more embodiments, the retention circuit 132 may operate for a time (e.g., predetermined time) upon receiving a second signal for activating the retention circuit from the retention activator 150. In one or more embodiments, the retention signal may be a signal for controlling the contactor drive circuit 134. For example, the retention signal may be a signal for opening the contactor 140, or a signal for closing the contactor 140.

According to one or more embodiments, the retention circuit 132 may receive a test signal from the controller 160 or from the retention activator 150. For example, the test signal may include a first signal and a second signal. In a case of receiving the test signal, the retention circuit 132 may be activated for a time (e.g., an amount of time, or predetermined time), and may output the retention signal.

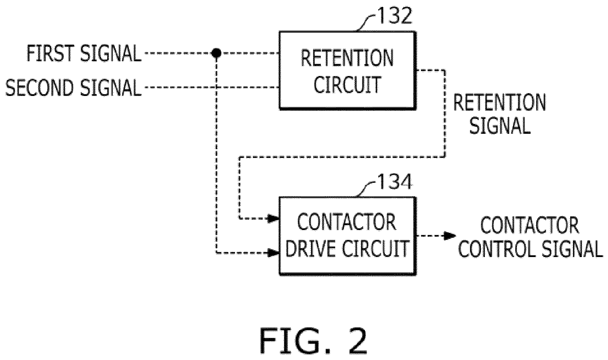

The contactor drive circuit 134 may receive a signal from at least one of the controller 160, the retention circuit 132, or the retention activator 150, and may output a signal for opening or closing the contactor 140 based on the received signal. A connection structure of the retention circuit 132 and the contactor drive circuit 134 will be described later with reference to FIG. 2.

The retention activator 150 may monitor a state of the controller 160, and if the controller 160 does not operate normally (e.g., performs an abnormal operation), the retention activator 150 may transmit, to the retention circuit 132, a second signal for activating the retention circuit 132. For example, the retention activator 150 may transmit the second signal to the retention circuit 132 for a time (e.g., predetermined time).

The controller 160 may include at least one of a general-purpose processor, a central processing unit (CPU), a microprocessor, a digital signal processor (DSP), a controller, a microcontroller, or a state machine. In some implementations, the controller 160 may include at least one of an application-specific integrated circuit (ASIC), a programmable logic device (PLD), or a field programmable gate array (FPGA). For example, the controller 160 may also be configured to include a combination of processing devices, such as a combination of a DSP and a microprocessor, a combination of a plurality of microprocessors, a combination of one or more microprocessors combined with a DSP core, or any other combination of configurations.

The controller 160 may be connected to, or may include, a memory device. In one or more embodiments, the memory device may be interpreted broadly to include any electronic component capable of storing electronic information. The memory device may include various types of processor-readable media, such as random access memory (RAM), read-only memory (ROM), non-volatile random access memory (NVRAM), programmable read-only memory (PROM), erasable-programmable read-only memory (EPROM), electrically erasable PROM (EEPROM), flash memory, a magnetic or optical data storage, a register, and so on. According to one or more embodiments, the memory device may store an algorithm and/or data for diagnosing a retention circuit according to the present disclosure.

The controller 160 may control respective components included in the retention circuit diagnostic system. The controller 160 may control the contactor 140, switches, etc. included in the retention circuit diagnostic system. According to one or more embodiments, the controller 160 may transmit a test signal including a first signal related to controlling a state of the contactor 140, and a second signal for activating the retention circuit 132. Thereafter, the controller 160 may obtain the retention signal output from the retention circuit 132, and may diagnose whether the retention circuit 132 is normal based on the obtained retention signal.

FIG. 2 illustrates a configuration of the retention device 130 of FIG. 1 according to one or more embodiments of the present disclosure. Referring to FIG. 2, an output of the retention circuit 132 may be input to the contactor drive circuit 134.

The retention circuit 132 may receive at least one of a first signal or a second signal. In one or more embodiments, the retention circuit 132 may receive the first signal from the controller 160, and may receive the second signal from the controller 160 or the retention activator 150. For example, the retention circuit 132 may include various circuit components, such as a switch, a flip-flop, a register, and a resistor.

According to one or more embodiments, the retention circuit 132 may be activated and may operate upon receiving the second signal. The retention circuit 132 might not operate in usual time, but may be activated upon receiving the second signal, and may transmit the retention signal to the contactor drive circuit 134. For example, upon receiving the second signal of a level (e.g., predetermined level, which may be a high level), the retention circuit 132 may be activated and may operate. If the retention circuit 132 is activated, the retention circuit 132 may output the retention signal for a time (e.g., predetermined time) based on the first signal. For example, if the first signal is a high signal, the retention circuit 132 may output a retention signal of a high level for a time (e.g., predetermined time), and if the first signal is a low signal, the retention circuit 132 may output a retention signal of a low level for a time (e.g., predetermined time).

The contactor drive circuit 134 may receive at least one of the first signal or the retention signal. In one or more embodiments, the contactor drive circuit 134 may receive the first signal from the controller 160, and may receive the retention signal from the retention circuit 132. The contactor drive circuit 134 may include various circuit components, such as a switch, a flip-flop, a register, and a resistor.

According to one or more embodiments, upon receiving the first signal, the contactor drive circuit 134 may output a contactor control signal for determining a state of the contactor 140 based on the first signal. For example, if the first signal is a high signal, the contactor drive circuit 134 may output a contactor control signal to close the contactor 140. In another example, if the first signal is a low signal, the contactor drive circuit 134 may output the contactor control signal to open the contactor 140.

Furthermore, if the first signal is not received from the controller 160 due to an abnormal operation of the controller 160, the contactor drive circuit 134 may receive the retention signal from the retention circuit 132 for a time (e.g., predetermined time). In one or more embodiments, the contactor drive circuit 134 may output the contactor control signal for determining a state of the contactor 140 based on the retention signal. For example, if the retention signal is a high signal, the contactor drive circuit 134 may output the contactor control signal to close the contactor 140. In another example, if the retention signal is a low signal, the contactor drive circuit 134 may output the contactor control signal to open the contactor 140.

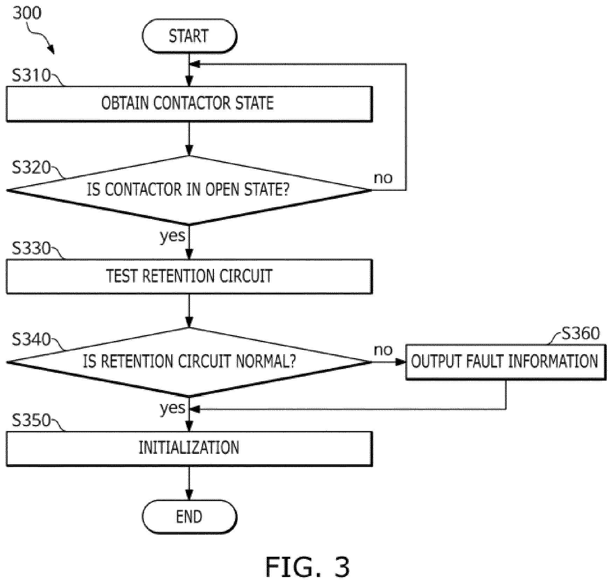

FIG. 3 illustrates a flowchart showing a diagnosis method 300 of a retention circuit, according to one or more embodiments of the present disclosure. The diagnosis method 300 illustrated in FIG. 3 may be performed by the controller 160 illustrated in FIG. 1. At a point in time (e.g., predetermined point in time), the controller 160 may start to perform the diagnosis method 300 of the retention circuit 132. In one or more embodiments, the time (e.g., predetermined time) may be a previously determined time, or a time at which power supply to a load is stopped (e.g., vehicle ignition is off).

In one or more embodiments, upon reaching the time to diagnose the retention circuit 132, the controller 160 may obtain a state of the contactor 140 (S310).

Thereafter, the controller 160 may determine whether the contactor 140 is in an open state based on the obtained state of the contactor 140 (S320). In one or more embodiments, the controller 160 may determine whether power is supplied to a load based on the state of the contactor 140.

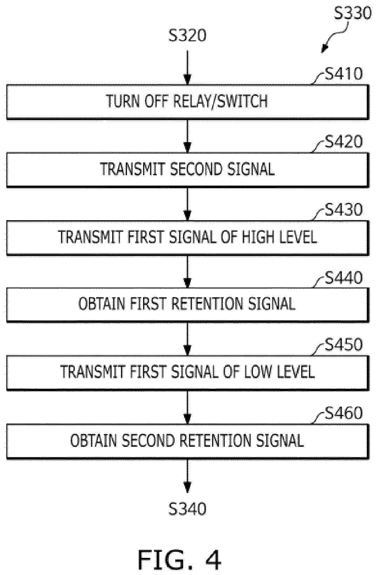

Subsequently, if it is determined that the contactor 140 is in an open state, the controller 160 may perform a test on the retention circuit 132 (S330). A method of testing the retention circuit 132 will be described below with reference to FIG. 4.

Thereafter, if the test is completed, the controller 160 may determine whether the retention circuit 132 is normal based on the test result (S340).

If it is determined that the retention circuit 132 is normal, the controller 160 may perform initialization of the retention circuit 132 (S350). Furthermore, the controller 160 may initialize a relay, a switch, and so on (S350). If initialization is performed, the retention circuit 132, the relay, the switch, and so on may be changed to a state (e.g., predetermined state) or to a previous state.

Furthermore, if the retention circuit is determined to be abnormal, the controller 160 may output fault information including a fault code on the retention circuit 132 (S360). If the fault information including the fault code is output, actions to resolve the fault, such as replacement of the retention circuit 132 or of a board including the retention circuit 132, may be performed.

The diagnosis method of one or more embodiments may be method corresponding to one cycle for performing a test, and the diagnosis method 300 illustrated in FIG. 3 may be repeatedly performed each time a diagnosis cycle arrives.

FIG. 4 illustrates a flowchart showing operation S330 of FIG. 3 in more detail, according to one or more embodiments of the present disclosure. Referring to FIG. 4, if the test for the retention circuit 132 is performed, the controller 160 may control relays, switches, contactors, and so on, such that the retention device 130 and the controller 160, which are test targets, may be connected to each other, and the remaining components may be disconnected from each other (S410). In one or more embodiments, the controller 160 may cause relays, switches, and so on to be turned off and may cause the contactor drive circuit 134 not to operate in response to a retention signal output by the test of the retention circuit 132. According to some embodiments, a switch may be provided on a connection line between the retention circuit 132 and the contactor drive circuit 134, and the switch may be turned off during the test. During the test, the likelihood of the retention signal output from the retention circuit 132 being input to the contactor drive circuit 134 may be reduced or the retention signal output from the retention circuit 132 may be prevented from being input to the contactor drive circuit 134.

Next, the controller 160 may transmit a second signal to the retention circuit 132 to test the retention circuit 132 (S420). Thereafter, the controller 160 may transmit a first signal of a high level to the retention circuit 132 (S430). Subsequently, a first retention signal may be output from the retention circuit 132 in response to the first and second signals of a high level, and the controller 160 may obtain the first retention signal output from the retention circuit 132 (S440).

Subsequently, the controller 160 may transmit the first signal of a low level to the retention circuit 132 (S450). Subsequently, a second retention signal may be output from the retention circuit 132 in response to the first and second signals of a low level, and the controller 160 may obtain the second retention signal output from the retention circuit 132 (S460).

The first and second retention signals may be output during the test, and if the first retention signal is included in a high level range (e.g., predetermined high level range) and the second retention signal is included in a low level range (e.g., predetermined low level range), it may be determined that the retention circuit 132 performs a normal operation. If the first retention signal is not within the high level range or if the second retention signal is not within the low level range, it may be determined that the retention circuit 132 performs an abnormal operation.

Furthermore, according to one or more other embodiments of the present disclosure, even if one retention circuit among a plurality of retention circuits performs an abnormal operation, a normal retention signal may be output from another retention circuit among the retention circuits.

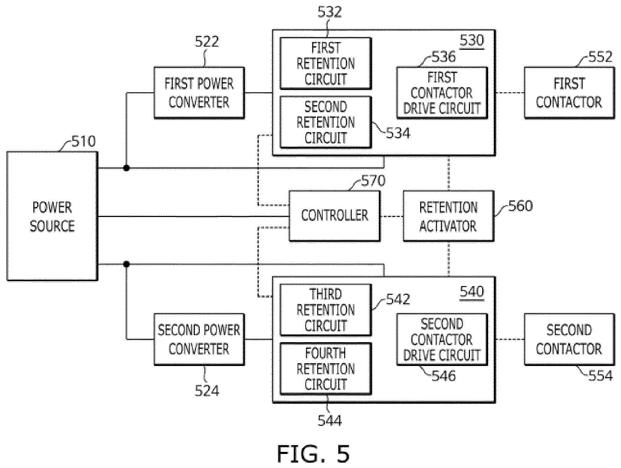

In one or more other embodiments described below with reference to FIGS. 5 to 7, redundant descriptions previously made with reference to FIGS. 1 to 4 will be omitted or shortened.

FIG. 5 illustrates a schematic diagram showing a retention circuit diagnostic system according to one or more other embodiments of the present disclosure. In FIG. 5 , a first contactor 552 may be connected to a high potential terminal (e.g., a positive terminal), and a second contactor 554 may be connected to a low potential terminal (e.g., a negative terminal).

Referring to FIG. 5, the retention circuit diagnostic system may include a power source 510, first and second power converters 522 and 524, first and second retention devices 530 and 540, first and second contactors 552 and 554, a retention activator 560, and a controller 570.

The power source 510 may supply power to respective components. Furthermore, the power source 510 may include a plurality of power sources of different standards. For example, the power source 510 may include a first power source, a second power source, a third power source, and so on, and the power capacity may gradually increase from the first power source to the third power source.

The first and second power converters 522 and 524 may receive power from the power source 510. The supplied power may be converted into power of an intended level, and the converted power may be supplied to the first and second retention devices 530 and 540. For example, the first power converter 522 may convert the DC power supplied by the power source 510 into DC power of a corresponding or specific level, and may supply the converted DC power to the first retention device 530. The second power converter 524 may convert the DC power supplied by the power source 510 into DC power of a corresponding or specific level, and may supply the converted DC power to the second retention device 540. A value of the DC power converted by the first power converter 522 may be different from a value of the DC power converted by the second power converter 524.

The first and second contactors 552 and 554 may be connected to a high potential terminal (e.g., a positive terminal) or a low potential terminal (e.g., a negative terminal) to form a path for supplying power to a corresponding terminal. For example, the first contactor 552 may be connected to a high potential terminal, and the second contactor 554 may be connected to a low potential terminal.

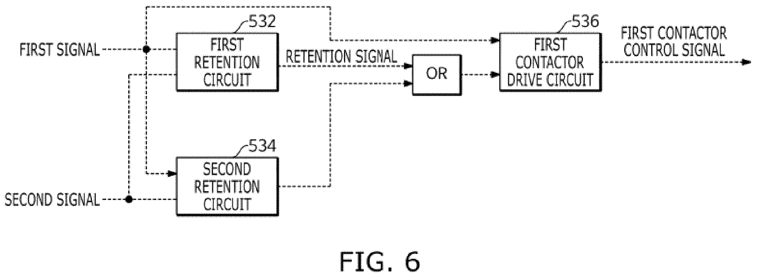

The first and second retention devices 530 and 540 may respectively include first, second, third, and fourth retention circuits 532, 534, 542, and 544 and first and second contactor drive circuits 536 and 546 to stably control the first and second contactors 552 and 554. Respective connection structures of the first, second, third, and fourth retention circuits 532, 534, 542, and 544 and the first and second contactor drive circuits 536 and 546 will be described below with reference to FIG. 6.

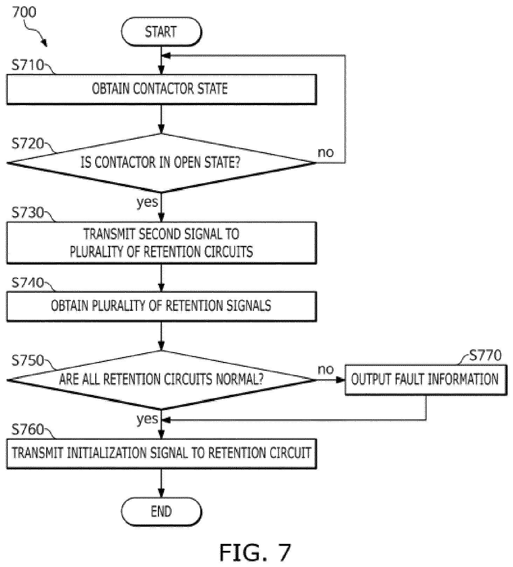

The controller 570 may perform diagnosis on the first, second, third, and fourth retention circuits 532, 534, 542, and 544. A diagnosis method of the first, second, third, and fourth retention circuits 532, 534, 542, and 544 by the controller 570 will be described below with reference to FIG. 7.

FIG. 6 illustrates a configuration of the first retention device 530 of FIG. 5 according to one or more other embodiments of the present disclosure. Because the second retention device 540 is configured substantially similarly or identically to the first retention device 530, only the first retention device 530 will be described.

Referring to FIG. 6, an output signal of the first retention circuit 532 and an output signal of the second retention circuit 534 may be "OR"ed (e.g., logically added) together, and the ORed signal may be input to the first contactor drive circuit 536. In one or more embodiments, if either a retention signal output from the first retention circuit 532 or a retention signal output from the second retention circuit 534 is in a high level, the retention signal associated with the high level may be input to the first contactor drive circuit 536.

The first retention circuit 532 and the second retention circuit 534 may receive at least one of a first signal or a second signal. In one or more embodiments, the first retention circuit 532 and the second retention circuit 534 may receive the first signal from the controller 570, and may receive the second signal from the controller 570 or the retention activator 560.

According to one or more embodiments, the first retention circuit 532 and the second retention circuit 534 may be activated and may operate upon receiving the second signal. The first retention circuit 532 and the second retention circuit 534 do not operate in usual time, and if receiving the second signal, the first retention circuit 532 and the second retention circuit 534 may be activated and may each transmit a retention signal to the first contactor drive circuit 536.

According to the configuration of the first retention device 530, although the first retention circuit 532 does not perform a normal operation, the second retention circuit 534 may output a retention signal of a level that is substantially equal to the level of the retention signal output from the first retention circuit 532, and a normal retention signal may be transmitted to the first contactor drive circuit 536.

FIG. 7 illustrates a flowchart showing a diagnosis method 700 of a retention circuit, according to one or more other embodiments of the present disclosure. The diagnosis method illustrated in FIG. 7 may be performed by the controller 570 illustrated in FIG. 5. At a point in time (e.g., predetermined point in time), the controller 570 may start to perform the diagnosis method 700 of a plurality of retention circuits. In one or more embodiments, the time (e.g., predetermined time) may be a previously determined time or a time that power supply to a load is stopped (e.g., vehicle ignition is off).

In one or more embodiments, upon reaching the time to diagnose the retention circuit 132, the controller 570 may obtain a state of the first contactor 552 and a state of the second contactor 554 (S710).

Thereafter, the controller 570 may determine whether both the first contactor 552 and the second contactor 554 are in an open state based on the obtained states of the first and second contactors 552 and 554 (S720).

Subsequently, if it is determined that both the first contactor 552 and the second contactor 554 are in an open state, the controller 570 may transmit a second signal to a plurality of retention circuits to test the retention circuits (S730). According to one or more embodiments, the controller 570 may perform a test on a plurality of retention circuits by generating a test signal. The test signal may include a first signal, a second signal, and a third signal. In one or more embodiments, the first signal may be associated with a state control of the first contactor 552, the second signal may be associated with activation of a retention circuit, and the third signal may be associated with a state control of the second contactor 554.

Thereafter, the controller 570 may obtain a plurality of retention signals output from the first, second, third, and fourth retention circuits 532, 534, 542, and 544 (S740). For example, the controller 570 may transmit the first signal of a high level to the first retention circuit 532 and to the second retention circuit 534, and then may obtain a plurality of first retention signals output from each of the first retention circuit 532 and the second retention circuit 534. Furthermore, the controller 570 may transmit the first signal of a low level to each of the first retention circuit 532 and the second retention circuit 534, and then may obtain a second retention signal output from each of the first retention circuit 532 and the second retention circuit 534.

Furthermore, the controller 570 may transmit the third signal of a high level to each of the third retention circuit 542 and the fourth retention circuit 544, and then may obtain a plurality of third retention signals output from each of the third retention circuit 542 and the fourth retention circuit 544. Furthermore, the controller 570 may transmit the third signal of a low level to each of the third retention circuit 542 and the fourth retention circuit 544, and then may obtain a fourth retention signal output from each of the third retention circuit 542 and the fourth retention circuit 544.

Subsequently, the controller 570 may determine whether each of the retention circuits performs a normal operation based on the obtained retention signals (S750). According to one or more embodiments, if each of the retention signals is within a level (e.g., predetermined level) range, the controller 570 may determine that the retention circuit outputting the related retention signal performs a normal operation.

If it is determined that all retention circuits perform normal operations, the controller 570 may initialize the retention circuits, a relay, a switch, and so on (S760).

Furthermore, if it is determined that at least one of the first, second, third, and fourth retention circuits 532, 534, 542, and 544 performs an abnormal operation, the controller 570 may output fault information including a fault code of the retention circuit (S770). In one or more embodiments, the controller 570 may include, in the fault information, a fault code indicating a retention circuit, which performs an abnormal operation. If the fault information including the fault code is output, actions to resolve the fault, such as replacement of the retention circuit 132 or a board including the retention circuit 132, may be performed.

The diagnosis method of one or more embodiments may be a method corresponding to one cycle for performing a test, and the diagnosis method 700 illustrated in FIG. 7 may be repeatedly performed each time a diagnosis cycle arrives.

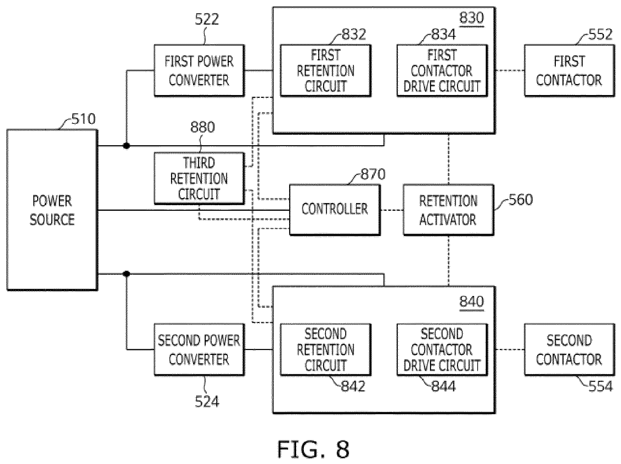

FIG. 8 illustrates a schematic diagram showing a retention circuit diagnostic system according to one or more other embodiments of the present disclosure. It may be seen that the number of retention circuits included in the retention circuit diagnostic system illustrated in FIG. 8 is less the number of retention circuits included in the retention circuit diagnostic system illustrated in FIG. 5. Among the components illustrated in FIG. 8, components having the same reference numerals as the components illustrated in FIG. 5 perform the same or similar functions, and components having different reference numerals will be mainly described.

Referring to FIG. 8, a retention circuit diagnostic system may include a power source 510, first and second power converters 522 and 524, first and second retention devices 830 and 840, first and second contactors 552 and 554, a retention activator 560, a third retention circuit 880, and a controller 870.

According to one or more embodiments of the present disclosure, even if the first retention circuit 832 included in the first retention device 830, or the second retention circuit 842 included in the second retention device 840, performs an abnormal operation, a normal retention signal may be output by the third retention circuit 880.

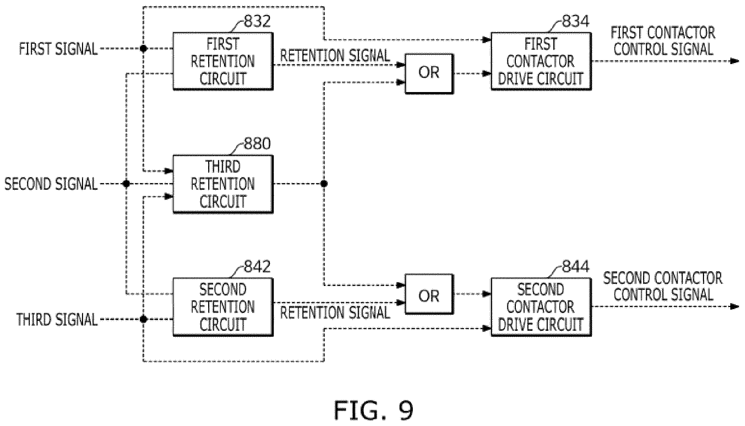

The first and second retention devices 830 and 840 may include the first and second retention circuits 832 and 842 and the first and second contactor drive circuits 834 and 844 to stably control the first and second contactors 552 and 554. Furthermore, the first and second retention circuits 832 and 842 may be connected to the third retention circuit 880. A connection structure of the first retention circuit 832, the second retention circuit 842, and the third retention circuit 880 will be described below with reference to FIG. 9.

The controller 870 may perform diagnosis on the first and second retention circuits 832 and 842. As described with reference to FIG. 7, the controller 870 may perform diagnosis on each of the first and second retention circuits 832 and 842, and if it is determined that at least one of the first, second, or third retention circuits 832, 842, and 880 performs an abnormal operation as a result of the diagnosis, the controller 870 may generate and output fault information. In one or more embodiments, the controller 870 may generate a test signal including a first signal, a second signal, and a third signal, and may perform diagnosis on each of the first, second, and third retention circuits 832, 842, and 880 in response to retention signals output from the first, second, and third retention circuits 832, 842, and 880.

FIG. 9 illustrates a connection structure of a plurality of retention circuits according to one or more other embodiments of the present disclosure.

Referring to FIG. 9, the first retention circuit 832 and the third retention circuit 880 may receive at least one of a first signal or a second signal. In one or more embodiments, the first retention circuit 832 and the third retention circuit 880 may receive the first signal from the controller 870, and may receive the second signal from the controller 870 or the retention activator 560. In one or more embodiments, the first signal may be a signal for controlling the first contactor 552, and the second signal may be a signal related to activations of the first, second, and third retention circuits 832, 842, and 880.

Furthermore, the second retention circuit 842 and the third retention circuit 880 may receive at least one of the second signal or the third signal. In one or more embodiments, the first retention circuit 832 and the third retention circuit 880 may receive the third signal from the controller 870, and may receive the second signal from the controller 870 or the retention activator 560. In one or more embodiments, the third signal may be a signal for controlling the second contactor 554.

An output signal of the first retention circuit 832 and an output signal of the third retention circuit 880 may be "ORed" (e.g., logically added) together, and the ORed signal may be input to the first contactor drive circuit 834. In one or more embodiments, if either a retention signal output from the first retention circuit 832 or a retention signal output from the third retention circuit 880 is in a high level, the retention signal associated with the high level may be input to the first contactor drive circuit 834.

Furthermore, an output signal of the second retention circuit 842 and the output signal of the third retention circuit 880 may be ORed/logically added together, and the ORed signal may be input to the second contactor drive circuit 844. In one or more embodiments, if either a retention signal output from the second retention circuit 842 or a retention signal output from the third retention circuit 880 is in a high level, the retention signal associated with the high level may be input to the second contactor drive circuit 844.

Even if the first retention circuit 832 or the second retention circuit 842 does not perform a normal operation, the third retention circuit 880 may output a retention signal of a level equal to the level of the retention signal output from the first retention circuit 832 or the second retention circuit 842, and a normal retention signal may be transmitted to the first contactor drive circuit 834 or the second contactor drive circuit 844.

The above-described method may be provided as a computer program stored in a computer-readable recording medium (for example, a memory device or so on) to be executed by a computer. The computer-readable recording medium may continuously store a program that may be executed by a computer or may temporarily store the program for execution or download. Furthermore, the computer-readable recording medium may be a variety of recording devices or storages in which a single or several pieces of hardware are combined with each other and may be distributed over a network without being limited to a medium directly connected to a computer system. The computer-readable recording medium may be configured to store program instructions by including, for example, a magnetic medium, such as a hard disk, a floppy disk, or a magnetic tape, an optical recording medium, such as compact disk-read only memory (CD-ROM) or digital video disk (DVD), a magneto-optical medium, such as a floptical disk, ROM, random access memory (RAM), flash memory, or so on. Furthermore, in another example, the computer-readable recording medium may include recording or storage media managed by an app store that distributes applications, a site that supplies or distributes various types of software, a server, or so on.

Although the present disclosure has been described above with respect to embodiments thereof, the present disclosure is not limited thereto. Various modifications and variations can be made thereto by those skilled in the art within the scope of the appended claims.

### DESCRIPTION OF SOME REFERENCE SYMBOLS

| | | | |
|---|---|---|---|
| 110: | power source | 120: | power converter |
| 130: | retention device | 132: | retention circuit |
| 134: | contactor drive circuit | 140: | contactor |
| 150: | retention activator | 160: | controller |

## Claims

1. A retention circuit diagnostic system comprising:
a first retention circuit (132) configured to output a retention signal for controlling a first contactor (140); and
a controller (160) configured to transmit a first signal related to a state control of the first contactor (140), **characterized in that** the controller (160) is further configured to transmit a second signal for activating the first retention circuit (132), and configured to diagnose the first retention circuit (132) based on the retention signal.

2. The retention circuit diagnostic system as claimed in claim 1, wherein the controller (160) is configured to determine that the first retention circuit (132) operates normally based on the retention signal being within a predetermined level range.

3. The retention circuit diagnostic system as claimed in claim 1 or claim 2, wherein the controller (160) is configured to determine whether the first contactor (140) is in an open state or in a closed state, and is configured to transmit the second signal to the first retention circuit (132) based on the first contactor (140) being in the open state.

4. The retention circuit diagnostic system as claimed in any one of the preceding claims, wherein the controller (160) is configured to initialize the first retention circuit (132) based on completion of a diagnosis of the first retention circuit.

5. The retention circuit diagnostic system as claimed in any one of the preceding claims, wherein the controller (160) is configured to output fault information based on the first retention circuit (132) performing an abnormal operation.

6. The retention circuit diagnostic system as claimed in any one of the preceding claims, further comprising a second retention circuit (534),
wherein the controller (570) is configured to transmit the first signal and the second signal to the second retention circuit (534), and to diagnose the second retention circuit (534) based on a retention signal output from the second retention circuit (534).

7. The retention circuit diagnostic system as claimed in claim 6, further comprising a contactor drive circuit (536) configured to drive the first contactor (552),
wherein the retention signal output from the first retention circuit (532) and the retention signal output from the second retention circuit (534) are logically added together to generate an ORed signal to be input to the contactor drive circuit (536).

8. The retention circuit diagnostic system as claimed in claim 6 or claim 7, wherein the first retention circuit (532) is configured to receive at least one of the first signal or the second signal, and
wherein the second retention circuit (534) is configured to receive at least one of the first signal or the second signal.

9. The retention circuit diagnostic system as claimed in any one of the preceding claims, further comprising a second retention circuit (524) configured to output a second retention signal for controlling a second contactor (554),
wherein the controller (870) is configured to generate a test signal for testing each of the first retention circuit (832) and the second retention circuit (842), and is configured to diagnose at least one of the first retention circuit (832) or the second retention circuit (842) based on at least one of the first retention signal or the second retention signal.

10. The retention circuit diagnostic system as claimed in claim 9, wherein the controller (870) is configured to determine that the first retention circuit (832) performs an abnormal operation based on the first retention signal being out of a level range.

11. The retention circuit diagnostic system as claimed in claim 9 or claim 10, wherein the controller (870) is configured to output fault information based on one of the first retention circuit (832) or the second retention circuit (842) performing an abnormal operation.

12. The retention circuit diagnostic system as claimed in any one of claims 9 to 11, further comprising a third retention circuit (880),
wherein the controller (870) is configured to diagnose the third retention circuit (880) based on a third retention signal output from the third retention circuit (880) based on the test signal.

13. The retention circuit diagnostic system as claimed in claim 12, further comprising:
a first contactor drive circuit (834) configured to drive the first contactor (552); and
a second contactor drive circuit (844) configured to drive the second contactor (554),
wherein the first retention signal and the third retention signal are logically added together to generate an ORed signal input to the first contactor drive circuit (834), and
wherein the second retention signal and the third retention signal are logically added together to generate another ORed signal input to the second contactor drive circuit (844).

14. The retention circuit diagnostic system as claimed in claim 12 or claim 13, wherein the test signal comprises a first signal related to a state control of the first contactor (552), a second signal for activating the first retention circuit (832), the second retention circuit (842), and the third retention circuit (880), and a third signal related to a state control of the second contactor (554),
wherein at least one of the first signal or the second signal is input to the first retention circuit (832),
wherein at least one of the second signal or the third signal is input to the second retention circuit (842), and
wherein at least one of the first signal, the second signal, or the third signal is input to the third retention circuit (880).

15. The retention circuit diagnostic system as claimed in any one of claims 9 to 14, wherein the first contactor (552) is connected to a high potential terminal, and wherein the second contactor (554) is connected to a low potential terminal.

## Patentansprüche

1. System zur Diagnose einer Halteschaltung, umfassend:
eine erste Halteschaltung (132), die so konfiguriert ist, dass sie ein Haltesignal zum Steuern eines ersten Schützes (140) ausgibt; und
eine Steuereinheit (160), die so konfiguriert ist, dass sie ein erstes Signal zur Zustandssteuerung des ersten Schützes (140) überträgt, **dadurch gekennzeichnet, dass** die Steuereinheit (160) ferner so konfiguriert ist, dass sie ein zweites Signal zum Aktivieren der ersten Halteschaltung (132) überträgt, und so konfiguriert ist, dass sie auf Basis des Haltesignals die erste Halteschaltung (132) diagnostiziert.

2. System zur Diagnose einer Halteschaltung nach Anspruch 1, wobei die Steuereinheit (160) so konfiguriert ist, dass sie auf Basis des Haltesignals innerhalb eines vorbestimmten Pegelbereichs bestimmt, dass die erste Halteschaltung (132) normal funktioniert.

3. System zur Diagnose einer Halteschaltung nach Anspruch 1 oder Anspruch 2, wobei die Steuereinheit (160) so konfiguriert ist, dass sie bestimmt, ob sich der erste Schütz (140) in einem offenen Zustand oder in einem geschlossenen Zustand befindet, und so konfiguriert ist, dass sie das zweite Signal an die erste Halteschaltung (132) basierend darauf überträgt, ob sich der erste Schütz (140) im offenen Zustand befindet.

4. System zur Diagnose einer Halteschaltung nach einem der vorstehenden Ansprüche, wobei die Steuereinheit (160) so konfiguriert ist, dass sie die erste Halteschaltung (132) auf Basis eines Abschlusses einer Diagnose der ersten Halteschaltung initialisiert.

5. System zur Diagnose einer Halteschaltung nach einem der vorstehenden Ansprüche, wobei die Steuereinheit (160) so konfiguriert ist, dass sie Fehlerinformationen basierend darauf ausgibt, ob die erste Halteschaltung (132) einen anormalen Betrieb durchführt.

6. System zur Diagnose einer Halteschaltung nach einem der vorstehenden Ansprüche, ferner umfassend eine zweite Halteschaltung (534),
wobei die Steuereinheit (570) so konfiguriert ist, dass sie das erste Signal und das zweite Signal an die zweite Halteschaltung (534) überträgt und die zweite Halteschaltung (534) auf Basis eines von der zweiten Halteschaltung (534) ausgegebenen Haltesignals diagnostiziert.

7. System zur Diagnose einer Halteschaltung nach Anspruch 6, ferner umfassend eine Schützansteuerschaltung (536), die zum Ansteuern des ersten Schützes (552) konfiguriert ist,
wobei das von der ersten Halteschaltung (532) ausgegebene Haltesignal und das von der zweiten Halteschaltung (534) ausgegebene Haltesignal logisch addiert werden, um ein ODER-verknüpftes Signal zu erzeugen, das in den Schützansteuerkreis (536) eingegeben wird.

8. System zur Diagnose einer Halteschaltung nach Anspruch 6 oder Anspruch 7, wobei die erste Halteschaltung (532) so konfiguriert ist, dass sie mindestens eines des ersten Signals oder des zweiten Signals empfängt, und
wobei die zweite Halteschaltung (534) so konfiguriert ist, dass sie mindestens eines des ersten Signals oder des zweiten Signals empfängt.

9. System zur Diagnose einer Halteschaltung nach einem der vorstehenden Ansprüche, ferner umfassend eine zweite Halteschaltung (524), die so konfiguriert ist, dass sie ein zweites Haltesignal zur Steuerung eines zweiten Schützes (554) ausgibt,
wobei die Steuereinheit (870) so konfiguriert ist, dass sie ein Testsignal zum Testen jeder der ersten Halteschaltung (832) und der zweiten Halteschaltung (842) erzeugt, und so konfiguriert ist, dass sie mindestens eine der ersten Halteschaltung (832) und der zweiten Halteschaltung (842) auf Basis mindestens eines des ersten Haltesignals oder des zweiten Haltesignals diagnostiziert.

10. System zur Diagnose einer Halteschaltung nach Anspruch 9, wobei die Steuereinheit (870) so konfiguriert ist, dass sie bestimmt, dass die erste Halteschaltung (832) einen anormalen Betrieb durchführt, basierend darauf, ob das erste Haltesignal außerhalb eines Pegelbereichs liegt.

11. System zur Diagnose einer Halteschaltung nach Anspruch 9 oder Anspruch 10, wobei die Steuereinheit (870) so konfiguriert ist, dass sie Fehlerinformationen basierend darauf ausgibt, ob eine der ersten Halteschaltung (832) oder der zweiten Halteschaltung (842) einen anormalen Betrieb durchführt.

12. System zur Diagnose einer Halteschaltung nach einem der Ansprüche 9 bis 11, ferner umfassend eine dritte Halteschaltung (880),
wobei die Steuereinheit (870) so konfiguriert ist, dass sie die dritte Halteschaltung (880) auf Basis eines dritten Haltesignals diagnostiziert, das von der dritten Halteschaltung (880) auf Basis des Testsignals ausgegeben wird.

13. System zur Diagnose einer Halteschaltung nach Anspruch 12, das ferner Folgendes umfasst:
eine erste Schützansteuerschaltung (834), die zum Ansteuern des ersten Schützes (552) konfiguriert ist; und
eine zweite Schützansteuerschaltung (844), die zum Ansteuern des zweiten Schützes (554) konfiguriert ist,
wobei das erste Haltesignal und das dritte Haltesignal logisch addiert werden, um ein ODER-verknüpftes Eingangssignal für die erste Schützansteuerschaltung (834) zu erzeugen, und
wobei das zweite Haltesignal und das dritte Haltesignal logisch addiert werden, um ein weiteres ODER-verknüpftes Eingangssignal zu erzeugen, das in die zweite Schützansteuerschaltung (844) eingegeben wird.

14. System zur Diagnose einer Halteschaltung nach Anspruch 12 oder Anspruch 13, wobei das Testsignal ein erstes Signal zur Zustandssteuerung des ersten Schützes (552), ein zweites Signal zur Aktivierung der ersten Halteschaltung (832), der zweiten Halteschaltung (842) und der dritten Halteschaltung (880) sowie ein drittes Signal zur Zustandssteuerung des zweiten Schützes (554) umfasst,
wobei mindestens eines des ersten Signals oder des zweiten Signals in die erste Halteschaltung (832) eingegeben wird,
wobei mindestens eines des zweiten Signals oder des dritten Signals in die zweite Halteschaltung (842) eingegeben wird und
wobei mindestens eines des ersten Signals, des zweiten Signals oder des dritten Signals in die dritte Halteschaltung (880) eingegeben wird.

15. System zur Diagnose einer Halteschaltung nach einem der Ansprüche 9 bis 14, wobei der erste Schütz (552) mit einem Hochpotentialanschluss verbunden ist und wobei der zweite Schütz (554) mit einem Niederpotentialanschluss verbunden ist.

## Revendications

1. Système de diagnostic de circuit de rétention comprenant :
un premier circuit de rétention (132) configuré pour émettre un signal de rétention pour commander un premier contacteur (140) ; et
un dispositif de commande (160) configuré pour transmettre un premier signal se rapportant à une commande d'état du premier contacteur (140) **caractérisé en ce que** le dispositif de commande (160) est en outre configuré pour transmettre un deuxième signal pour activer le premier circuit de rétention (132), et configuré pour diagnostiquer le premier circuit de rétention (132) sur la base du signal de rétention.

2. Système de diagnostic de circuit de rétention selon la revendication 1, dans lequel le dispositif de commande (160) est configuré pour déterminer que le premier circuit de rétention (132) fonctionne normalement sur la base du signal de rétention qui est dans une plage de niveau prédéterminée.

3. Système de diagnostic de circuit de rétention selon la revendication 1 ou la revendication 2, dans lequel le dispositif de commande (160) est configuré pour déterminer si le premier contacteur (140) est dans un état ouvert ou dans un 'état fermé, et est configuré pour transmettre le deuxième signal au premier circuit de rétention (132) sur la base du premier contacteur (140) qui est dans l'état ouvert.

4. Système de diagnostic de circuit de rétention selon l'une quelconque des revendications précédentes, dans lequel le dispositif de commande (160) est configuré pour initialiser le premier circuit de rétention (132) sur la base de l'achèvement d'un diagnostic du premier circuit de rétention.

5. Système de diagnostic de circuit de rétention selon l'une quelconque des revendications précédentes, dans lequel le dispositif de commande (160) est configuré pour délivrer des informations de défaut sur la base du premier circuit de rétention (132). effectuant une opération anormale.

6. Système de diagnostic de circuit de rétention selon l'une quelconque des revendications précédentes, comprenant en outre un deuxième circuit de rétention (534),
dans lequel le dispositif de commande (570) est configuré pour transmettre le premier signal et le deuxième signal au deuxième circuit de rétention (534), et pour diagnostiquer le deuxième circuit de rétention (534) sur la base d'un signal de rétention émis à partir du deuxième circuit de rétention (534).

7. Système de diagnostic de circuit de rétention selon la revendication 6, comprenant en outre un circuit d'entraînement de contacteur (536) configuré pour entraîner le premier contacteur (552),
dans lequel le signal de rétention émis à partir du premier circuit de rétention (532) et le signal de rétention émis à partir du deuxième circuit de rétention (534) sont logiquement additionnés pour générer un signal mis en fonction OU à entrer dans le circuit d'entraînement du contacteur (536).

8. Système de diagnostic de circuit de rétention selon la revendication 6 ou la revendication 7, dans lequel le premier circuit de rétention (532) est configuré pour recevoir au moins un du premier signal ou du deuxième signal et.
dans lequel le deuxième circuit de rétention (534) est configuré pour recevoir au moins un du premier signal ou du deuxième signal.

9. Système de diagnostic de circuit de rétention selon l'une quelconque des revendications précédentes, comprenant en outre un deuxième circuit de rétention (524) configuré pour émettre un deuxième signal de rétention pour commander un second contacteur (554),
dans lequel le dispositif de commande (870) est configuré pour générer un signal de test pour tester chacun du premier circuit de rétention (832) et du deuxième circuit de rétention (842), et est configuré pour diagnostiquer au moins un du premier circuit de rétention (832) ou du deuxième circuit de rétention (842) sur la base d'au moins un du premier signal de rétention ou du deuxième signal de rétention.

10. Système de diagnostic du circuit de rétention selon la revendication 9, dans lequel le dispositif de commande (870) est configuré pour déterminer que le premier circuit de rétention (832) effectue une opération anormale sur la base du fait que le premier signal de rétention est en dehors d'une plage de niveau.

11. Système de diagnostic de circuit de rétention selon la revendication 9 ou la revendication 10, dans lequel le dispositif de commande (870) est configuré pour délivrer des informations de défaut sur la base de l'un du premier circuits de rétention (832) ou du deuxième circuit de rétention (842) effectuant une opération anormale.

12. Système de diagnostic de circuit de rétention selon l'une quelconque des revendications 9 à 11, comprenant en outre un troisième circuit de rétention (880),
dans lequel le dispositif de commande (870) est configuré pour diagnostiquer le troisième circuit de rétention (880) sur la base d'un troisième signal de rétention émis à partir du troisième circuit de rétention (880) sur la base du signal de test.

13. Système de diagnostic du circuit de rétention selon la revendication 12, comprenant en outre :
un premier circuit d'entraînement de contacteur (834) configuré pour entraîner le premier contacteur (552) ; et
un deuxième circuit d'entraînement de contacteur (844) configuré pour entraîner le second contacteur (554),
dans lequel le premier signal de rétention et le troisième signal de rétention sont additionnés logiquement pour générer un signal mis en fonction OU entré dans le premier circuit d'entraînement de contacteur (834), et
dans lequel le deuxième signal de rétention et le troisième signal de rétention sont logiquement additionnés pour générer un autre signal mis en fonction OU entré dans le deuxième circuit d'entraînement du contacteur (844).

14. Système de diagnostic de circuit de rétention selon la revendication 12 ou la revendication 13, dans lequel le signal de test comprend un premier signal se rapportant à une commande d'état du premier contacteur (552), un deuxième signal pour activer le premier circuit de rétention (832), le deuxième circuit de rétention (842) et le troisième circuit de rétention (880), et un troisième signal se rapportant à une commande d'état du second contacteur (554),
dans lequel au moins un du premier signal ou du deuxième signal est entré dans le premier circuit de rétention (832),
dans lequel au moins un du deuxième ou du troisième signal est entré dans le deuxième circuit de rétention (842), et
dans lequel au moins un du premier signal, du deuxièmes signal ou du troisième signal est entré dans le troisième circuit de rétention (880).

15. Système de diagnostic de circuit de rétention selon l'une quelconque des revendications 9 à 14, dans lequel le premier contacteur (552) est connecté à une borne à potentiel élevé et dans lequel le second contacteur (554) est connecté à une borne à faible potentiel.
